# EUROPEAN PATENT SPECIFICATION

(11) **EP 0 573 147 B1**
(45) Date of publication and mention of the grant of the patent: **26.06.1996**
(21) Application number: 93303258.3
(22) Date of filing: 27.04.1993
(51) Int. Cl.: H01R 9/16

(54) **Contact maintenance device for use in an electric part socket**
Kontakthalter für elektrische Buchse
Dispositif de maintien du contact pour connecteur électrique

(30) Priority: 01.05.1992 JP 139974/92
(43) Date of publication of application: 08.12.1993
(73) Proprietor: YAMAICHI ELECTRONICS CO., LTD., Ohta-ku, Tokyo (JP)
(72) Inventor: Matsuoka, Noriyuki, Yokohama-shi, Kanagawa-ken (JP)
(74) Representative: Ben-Nathan, Laurence Albert

(56) References cited:
- WO-A-89/02167
- WO-A-92/03857
- GB-A- 2 082 401
- US-A- 4 090 764
- US-A- 4 879 808

## Description

### BACKGROUND OF THE INVENTION

This invention relates to a socket for an electric part in which a press-down force is applied to an electric part body placed on a socket body, and more particularly to an electric part press-down device for maintaining a contacting condition between the electric part and the socket body.

Japanese Laid-Open Utility Model Publication No. Sho 60-57135, for example, discloses a typical electric part socket in that a press-down force is applied to an electric part placed on a socket body. In this conventional electric part socket, a basal end of a pressing cover is pivotally attached to one end of the socket body, an electric part body (or terminals) is pressed down by closing the pressing cover onto an upper surface of the socket body thereby flexing contacts of the socket body downwardly and obtaining a contacting pressure with the terminals by reaction thereof, and a lock lever turnably attached to the other end of the socket body is brought into engagement with a free end of the pressing cover to maintain the closing condition and thus to maintain the contacting condition.

However, in the socket thus constructed, the socket body and the pressing cover are generally the same in size, and when the pressing cover is closed onto the upper surface of the socket body, the electric part is almost entirely covered with the pressing cover and held in a half closed condition between the pressing cover and the socket body. As a result, heat of the electric part cannot be effectively radiated, and therefore the electric part is damaged by accumulated heat.

When the electric part is placed on and removed from the socket body, it is required to turn the pressing cover by more than 90 degrees in order to open the upper surface of the socket body and therefore, it becomes difficult to open and close the pressing cover by an automatic machine.

Since an upwardly directing force is acted on a central portion of the pressing cover by reaction of the contacts, the pressing cover is warped in a short time due to heat.

A difference in pressing timing occurs between the pivotal point side and the free end side of the pressing cover. Consequently, since the electric part is pressed first by the pivotal point side of the pressing over, the electric part is caused to be jumped, thereby givng rise to a poor contacting condition.

WO-A-8902167 discloses an electric coupling device having the features of the preamble of Claim 1.

The pair of levers of this device have the same pivot and extend in the same direction. Where an electric part is pressed by such a pair of levers rotating in the same direction, it is difficult to press the electric part at different positions at the same pressing timing, with the positional balance of the electric part kept constant, and to shift the electric part downward without changing the posture of the electric part. In other words, inclination and jumping of the electric part are induced.

### SUMMARY OF THE INVENTION

It is therefore a general object of the present invention to provide a contacting condition maintaining device for use in an electric part socket capable of solving the above-mentioned problems inherent in the prior art device.

The invention provides a contact condition maintaining device in accordance with Claim 1.

In some embodiments an actuator may be mounted on an upper part of the socket body for movement upwardly and downwardly and adapted to press down the pressing levers when the actuator is moved downwardly.

In further embodiments, a first actuator may be mounted on an upper part of the socket body for movement upwardly and downwardly and adapted to press down the pressing lever means when the first actuator is moved downwardly, with a second actuator mounted on an upper part of the socket body for movement upwardly and downwardly and adapted to displace the lock members to unlocking positions respectively.

### BRIEF DESCRIPTION OF THE DRAWINGS

Fig. 1 is a perspective view of an electric part socket according to one embodiment of the present invention, in which an actuator is in an uppermost position;
Fig. 2 is likewise a perspective view of the electric part socket of Fig. 1 but in which the actuator is in a lowermost position;
Fig. 3 is a perspective view of the electric part socket of Fig. 2 but with an electric part placed thereon;
Fig. 4 is a plan view of the electric part socket of Fig. 1;
Fig. 5 is a side view of the electric part socket of Fig. 1;
Fig. 6 is a plan view of the electric part socket of Fig. 2;
Fig. 7 is a cross-sectional view of the electric part socket taken on line A-A of Fig. 6, in which the actuator is in the uppermost position;
Fig. 8 is likewise a cross-sectional view of the electric part socket taken on line A-A of Fig. 6, in which the actuator is in the lowermost position;
Fig. 9 is likewise a cross-sectional view of the electric part socket taken on line A-A of Fig. 6, in which a lock member is in the course of being unlocked;
Fig. 10 is a schematic cross-sectional view of the electric part socket in which the actuator is in an uppermost position and the electric part is not yet placed on the socket;
Fig. 11 is a schematic cross-sectional view of the electric part socket of Fig. 10, but in which the electric part is placed on the socket;
Fig. 12 is a schematic cross-sectional view of the electric part socket of Fig. 11, but in which a first actuator is pressed down and as a result, the electric part is pressed down by the first actuator;
Fig. 13 is a schematic cross-sectional view of the electric part socket of Fig. 12, but in which a second actuator is pressed down and as a result, the lock member is unlocked by the second actuator;
Fig. 14 is a plan view of an important portion of an electric part socket of the present invention, showing a basic construction thereof; and
Fig. 15 is a plan view of an important portion of an electric part socket of Fig. 14 but according to a modified embodiment of the present invention.

### DETAILED DESCRIPTION OF THE EMBODIMENTS

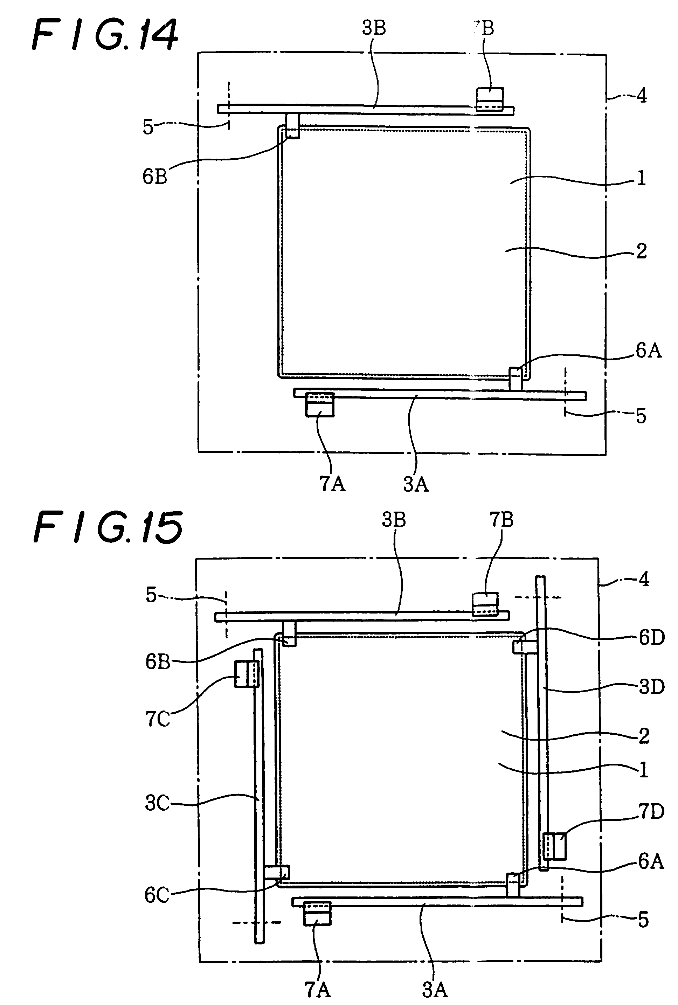

A basic construction of the present will be described first, with reference to embodiments of Figs. 14 and 15.

In Figs. 14 and 15, the numeral 1 denotes an electric part. As a typical example of the electric part, Figs. 14 and 15 show an LGA type IC including an electric part body 2 and a plurality of electric conductive pads arranged on a lower surface of the electric part body 2.

The reference symbols 3A and 3B denote pressing levers, respectively. As shown in Fig. 14, the pressing levers 14 and 15 are provided to two opposite sides of the electric part body 2 such that the pressing levers 14 and 15 are capable of turning upwardly and downwardly along the opposite sides. For example, one ends of the pressing levers 3A and 3B are turnably supported on a socket body 4 through axes 5, respectively, and the other ends extending along side surfaces of the electric part body 2 from the axes acting as pivotal points are defined as free ends, respectively.

Preferably, one end of the pressing lever 3A is supported on one end of the socket body 4 through one of the axes 5 such that the pressing lever 3A can be turned upwardly and downwardly on the axis 5, while one end of the pressing lever 3B is supported on the other end of the socket body 4 through the other axis 5 such that the pressing lever 3B can be turned upwardly and downwardly on the other axis 5. The pressing levers 3A and 3B extend in opposite directions with respect to each other from their pivotal points, respectively.

There are provided latches 6A and 6B which are brought into engagement with edge portions of the electric part body 2 respectively when the pressing levers 3A and 3B are turned downwardly, so as to apply a press-down force to the electric part body 2. In the example of Figs. 14 and 15, the latches 6A and 6B are integral with the pressing levers 3A and 3B respectively. As later described, however, the latches 6A and 6B may be formed as separate members from the pressing levers 3A and 3B respectively, and supported on the socket body 4 such that the latches 6A and 6B can be turned upwardly and downwardly. In this case, the latches are brought into engagement with the edge portions of the electric part body 2 respectively when the pressing levers 3A and 3B are turned downwardly, so as to press down the electric part body 2.

Preferably, the latches 6A and 6B are provided in the vicinity of the pivotal points of the pressing levers 3A and 3B respectively, so that when the pressing lever 3A is turned downwardly, the latch 6A is brought into engagement with one corner portion on a diagonal line of the electric part body 2, and when the pressing lever 3B is turned downwardly, the latch 6B is brought into engagement with the other corner portion on the diagonal line of the electric part body 2, thereby applying a downward force to the electric part body 2.

The electric part body 2 is applied at locations displaced from the extending directions of the pressing levers 3A and 3B with the press-down force by the latches 6A and 6B, respectively. As a result, a vertical parallel shifting is performed in a well-balanced manner.

The lock members 7A and 7B are turnably mounted on the socket body 4 such that when the pressing levers 3A and 3B are turned downwardly, the lock members 7A and 7B are brought into engagement with the free ends of the pressing levers 3A and 3B respectively. Although now shown, the lock members 7A and 7B may be brought into engagement with a member capable of contributing to press down the pressing levers 3A and 3B, such as for example a first actuator 24 as later described.

Due to engagement of the lock members 7A and 7B, the pressing levers 3A and 3B are prevented from being turned upwardly and downwardly, and the engaging condition of the latches 6A and 6B with the edge portions of the electric part body 2 and the pressing-down condition of the electric part body 2 are maintained. Furthermore, the terminals on a lower surface of the electric part body 2 are pressed against the contacts on the socket body 4, thereby maintaining the contacting condition therebetween.

The pressing levers 3A and 3B are resiliently held upwardly by springs, and when the lock members 7A and 7B are unlocked, the pressing levers 3A and 3B are automatically returned upwardly by upwardly directing pressing force of the springs. In accordance with the upward turning movement of the pressing levers 3A and 3B, the latches 6A and 6B are brought to be outside a surface area of an electric part placing space 8 by the upward turning movement of the pressing levers 3A and 3B.

Fig. 15 shows another example in which the pressing levers 3C and 3D are provided to the remaining two opposite sides of the electric part body 2. The constructions of the pressing levers 3C and 3D and the lock members 7C and 7D are exactly the same to the pressing levers 3A and 3B and the lock members 7A and 7B mentioned above.

In the example of Fig. 15, the pressing levers 3A to 3D are provided to the four sides of the electric part body 2 such that the pressing levers 3A and 3D can be turned upwardly and downwardly along the four sides. The latches 6A to 6D are brought into engagement with the four edges of the electric part body 2, thus enabling to uniformly apply the press-down force to the electric part body 2.

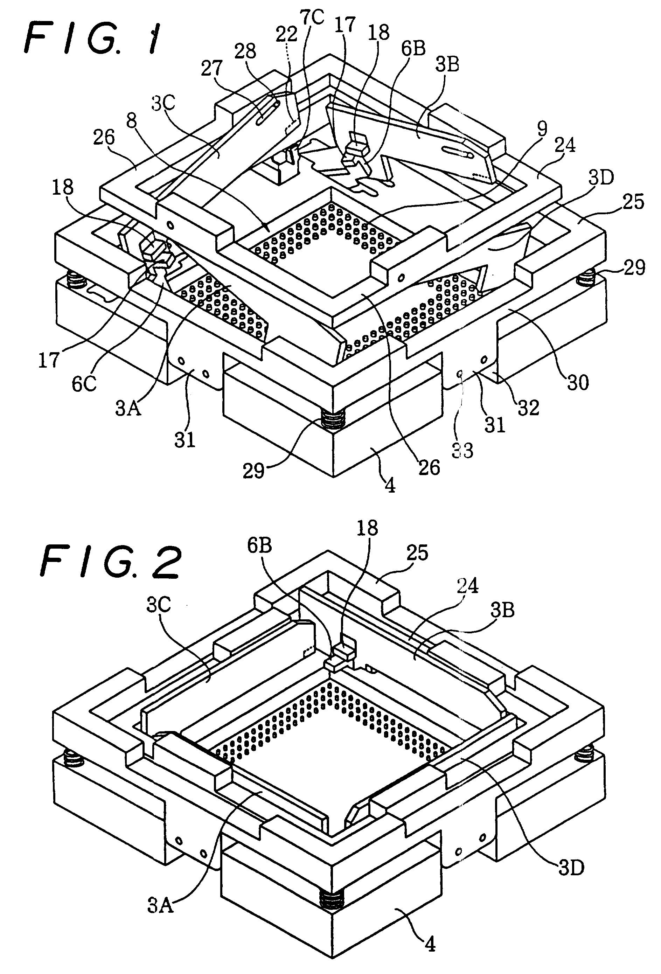

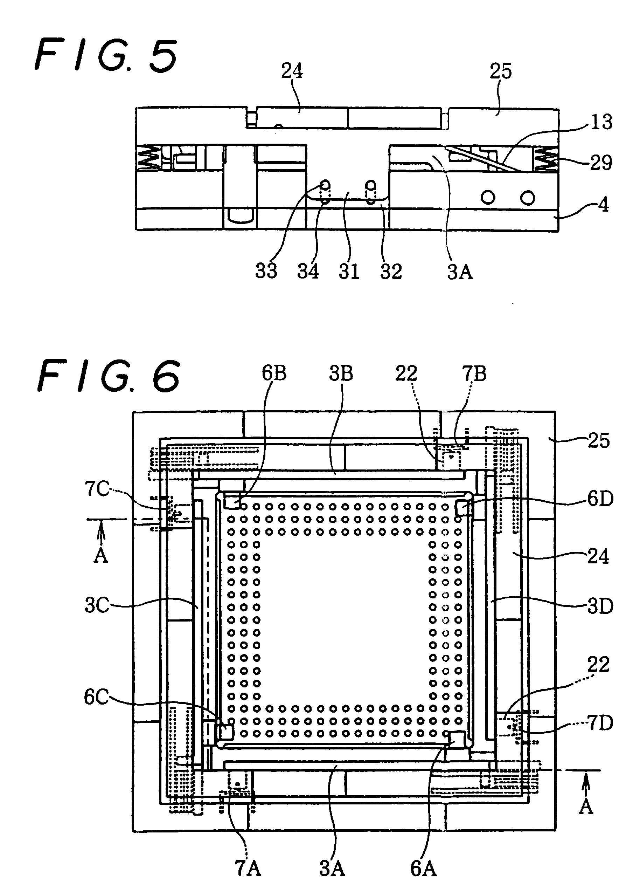

Next, concrete examples formed based on the basic construction of the present invention will be described with reference to Figs. 1 to 13. The socket body 4 is formed of an electrically-insulative material and has a generally square shape in plan view. The socket body 4 has a placing space 8 for receiving the electric part body 2 at an upper surface thereof. A number of contacts 9 are arranged on a bottom surface of the placing place 8.

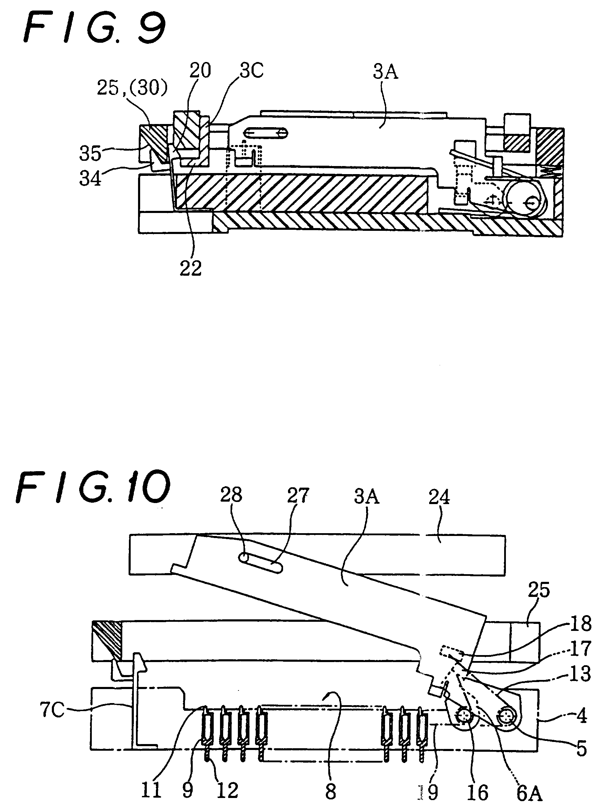

As shown in Fig. 10 and others, the contacts 9 have movably contacting members 11, respectively, which are capable of resiliently moving upwardly and downwardly. Upper ends of the contacting members 11 project upwardly from the bottom surface of the placing space 8 so as to correspond to the terminals formed of a number of electrically-conductive pads arranged on the lower surface of the electric part body 2. The arrangement being such that when the upper ends of the movable contacting members 11 are pressed by the terminals, the movable contacting members 11 are moved downwardly against the resiliency of the movable contacting members 11, and when the pressing force is removed, the movable contacting members 11 are moved upwardly by resiliency thereof.

Known contacts, in which for example the movable contacting members 11 are resiliently held by springs in sleeves respectively, can be used. Each contact may be of the known construction in which the contact is formed by bending an elongated element which can be compressed downwardly and restored upwardly.

Each contact 9 has a male terminal 12 projecting from a stationary contacting portion such as a sleeve embedded in the socket body 4 and adapted to contact the corresponding movable contacting member 11. The male terminal 12 of each contact 9 projects downwardly from the lower surface of the socket body 4 so as to contact a wiring board, etc.

The four pressing levers 3A, 3B, 3C and 3D are arranged along the four sides of the electric part body 2, in other words, along the four sides of the electric part placing space 8. The pressing levers 3A to 3D are supported at one ends thereof on the socket body 4 through the pins 5 respectively such that the pressing levers 3A to 3D can be turned upwardly and downwardly. The pressing levers 3A to 3D extend along the respective sides of the electric part body 2 from the pivotal points respectively, and the other ends of the pressing levers 3A to 3D are defined by free ends respectively.

The preferred two opposite pressing levers 3A and 3B will be described. One of the pressing levers, i.e., the pressing lever 3A is turnably supported at one end of the socket body 4, and the other pressing lever 3B is turnably supported at the other end of the socket body 4. The pressing levers 3A and 3B extend in opposite directions with respect to each other from their pivotal points, respectively. The remaining two opposite pressing levers 3C and 3D also extend in opposite directions with respect to each other from their pivotal points, respectively. The pressing levers 3A to 3D are resiliently held at the neighborhoods of the pivotal points respectively so that upwardly turning force is normally applied to the pressing levers 3A to 3D.

The latches 6A to 6D are provided to the neighborhoods of the pivotal points of the pressing levers 3A to 3D, respectively, and the lock members 7A to 7D are provided to the neighborhoods of the free ends of the pressing levers 3A to 3D, respectively. The latches 6A to 6D are supported on the socket body 4 through pins 16 adjacent to the pins 5, respectively such that the latches 6A to 6D can be turned upwardly and downwardly. Each of the latches 6A to 6D is provided at a distal end thereof with a retaining claw element 17 bent towards the placing space 8. As shown in Fig. 10, each of the latches 6A to 6D is resiliently held at the pivotal point area by another forked spring 19 such that upwardly turning force is applied to each of the latches 6A to 6D.

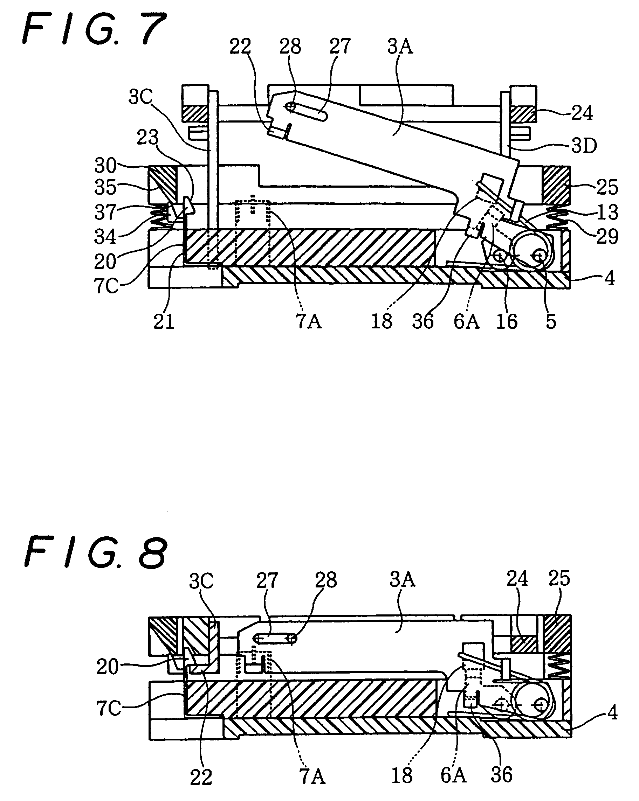

As shown in Fig. 7 and others, a lower surface of a distal end portion of each of the latches 6A to 6D is supported by a push-up element 36 projecting from each of the pressing levers 3A to 3D so as to turn the each of the latches 6A to 6D upwardly. Accordingly, each of the latches 6A to 6D are turned upwardly and downwardly by the push-down element 18 and the push-up element 36 in accordance with the movement of each of the pressing levers 3A to 3D. Either the forked spring 19 or the push-up element 18 may be selected for use.

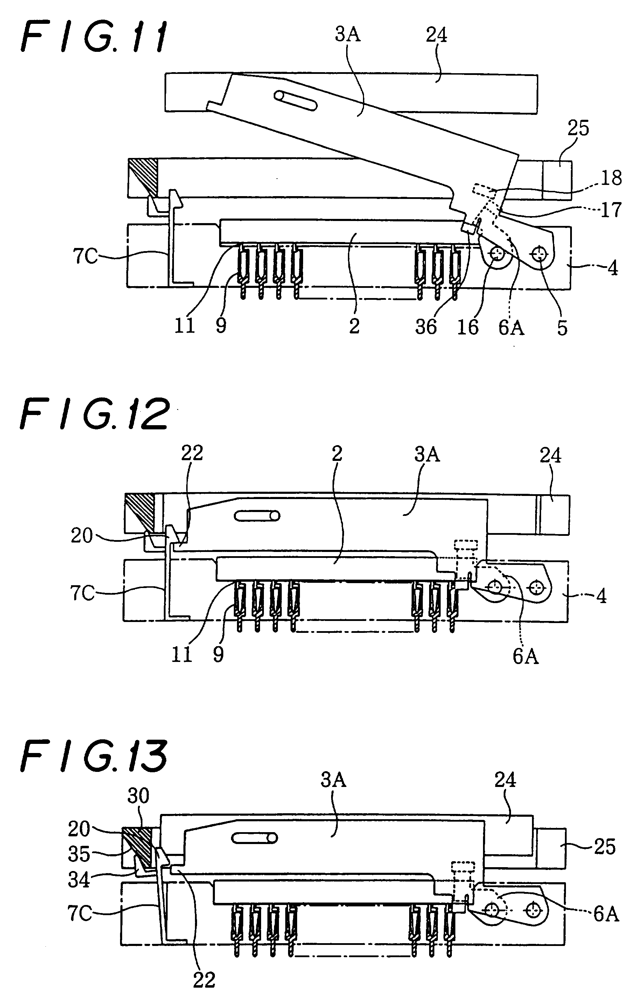

The press-down element 18 projects from each of the pressing levers 3A-3D positioned at an upper part of each of the latches 6A to 6D, i.e., an upper part of the retaining claw element 17. As shown in Figs. 10, 11 and others, when each of the pressing levers 3A to 3D is turned upwardly by resiliency of each spring 13, each of the press-down element 18 removes the pressure of each of the latches 6A to 6D, and when each of the pressing levers 3A to 3D is turned downwardly against the resiliency of each spring 13, the retaining claw element 17 of each of the latches 6A to 6D is pressed down to turn each of the latches 6A to 6D downwardly. In accordance with this downward turning movement of each of the latches 6A to 6D, the retaining claw element 17 is brought into engagement with the edge portion of the electric part body 2, thereby applying a press-down force to the electric part body 2.

The press-down force applied to the free end of each of the pressing levers 3A to 3D is amplified by lever function of each lever and then applied to each of the latches 6A to 6D.

Although there has been described an example in which the latches 6A to 6D are formed as separate parts from the pressing levers 3A to 3D respectively and the electric part body 2 is indirectly pushed down, the present invention includes a case where the latches 6A to 6D integrally project from the pressing levers 3A to 3D respectively as shown in Figs. 14 and 15.

Preferably, the latches 6A to 6D are arranged in such a manner as to be engageable with the respective corner portions of the electric part body 2 respectively so as to apply press-down force to the electric part body 2. For example, if attention is paid to the above-mentioned two opposite pressing levers 3A and 3B, by virtue of the arrangement that the two pressing levers 3A and 3B are pivotally supported on the opposite side end portions with respect to each other of the socket body 4 and extend in the opposite direction with respect to each other from the pivotal points respectively, and the latches 6A and 6B are arranged one-sided to the pivotal points respectively, the latches 6A and 6B are respectively engageable with the edge portions of the electric part body 2 at a location displaced from an extending direction of each of said pressing levers 3A and 3B. The pressing levers 6C and 6D are also arranged in the same way. Owing to this arrangement, the latches 6A to 6D are brought into engagement with the edge portions of the neighborhoods of the corner portions of the electric part body 2 so as to apply pressing force to the electric part body 2.

Owing to the above-mentioned arrangement of the latches 6A to 6D, the latches can be brought into engagement with the edge portions of the electric part body at the same timing, and also can shift the electric part body upwardly and downwardly in parallel and well-balanced condition. As a result, there can be obtained proper contacting conditions between the individual contacts and the corresponding individual terminals.

As means for holding the downward turning of each of the pressing levers 3A to 3D, the lock members 7A to 7D are provided to the socket body 4. The lock members 7A to 7D are engageable with the free end portions of the pressing levers 3A to 3D respectively or engageable with first actuator 24 as later described so as to prevent the pressing levers from turning upwardly.

As one concrete example, the lock members 7A to 7D are raised upwardly as indicated by the numeral 21 from the lower positions for the pressing levers turned downwardly, and lower ends of the raised portions 21 are mounted to the socket body 4 and upper ends thereof are provided with hook portions 20 respectively such that the hook portions 20 can be shifted inwardly and outwardly by resiliency of the raised portions 21.

On the other hand, the free ends of the pressing levers 3A to 3D are provided with retaining claw elements 22 respectively projecting sidewardly, such that the retaining claw elements 22 are vertically corresponding to the hook portions 20 respectively.

When the pressing levers 3A to 3D are turned downwardly, the retaining claw elements 22 are brought into abutment with slant surfaces 23 formed on top surfaces of the hook portions 20 respectively, and then displace, while sliding on the slant surfaces 23, the hooks 20 against resiliency of the raised portions 21. When the retaining claw elements 22 has passed the slant surfaces, the hooks 20 are restored inwardly and brought into engagement with the retaining claw elements 22 respectively.

As a result, the pressing levers 3A to 3D are prevented from being turned upwardly, the pressing down condition of the electric part achieved by the latches 6A to 6D is maintained, and the pressure contacting condition between each contact 9 and each electric part terminal can be maintained.

The force directing upwardly is normally acted on to the pressing levers 3A to 3D by the springs 13. When the lock members 7A to 7D are unlocked, the pressing levers 3A to 3D as well as the latches 6A to 6D are automatically turned upwardly to remove the pressing down condition made to the electric part body 2 by the latches 6A to 6D, thereby enabling to place and remove the electric part. At this time, the latches 6A to 6D are brought outside the placing space 8.

As operation means for pressing down the pressing levers 3A to 3D simultaneously, there is provided a first actuator 24, and as operation means for removing the engagements of the lock members 7A to 7D, there is provided a second actuator 25.

The first and second actuators 24 and 25 are formed of square frames respectively, and are disposed at an upper portion of the socket body 4 such that the first and second actuators 24 and 25 can be moved upwardly and downwardly. The first and second actuators 24 and 25 are arranged such that the second actuator 25 is located at an inner side of the first actuator 24, or the first actuator 24 is located at an inner side of the second actuator 25. The placing space 8 is disposed right under and opposite to a window defined by frame elements of the first and second actuators 24 and 25.

More specifically, the frames constituting the first and second actuators 24 and 25 surround the placing space 8, and the electric part is placed on and removed from the placing space through the window.

Frame elements 26 constituting the first actuator 24, are connected to the pressing levers 3A to 3D respectively through the loosely supporting points (pivotal points).

For example, the free end of each of the pressing levers 3A to 3D is provided with a guide hole 27 which is formed of an elongated slot directing in the extending direction of the pressing lever. A guide pin 28 projecting from an inner surface of each frame element 26 is slide fitted into the guide hole 27.

As mentioned above, when the pressing levers 3A to 3D are turned upwardly by the springs 13 respectively, the press-down force of the springs 13 is applied to the first actuator 24 through the connecting portions (loosely supporting points). As a result, the first actuator 24, while causing the guide pins 28 to move from inner ends toward outer ends of the guide holes 27 respectively, is moved upwardly in connection with the upwardly turning motion of the pressing levers 3A to 3D. When the guide pins 28 are brought into abutment with the outer ends of the guide holes 27 respectively, the pressing levers 3A to 3D are prevented from being turned upwardly and the first actuator 24 is prevented from being moved upwardly.

As shown in Figs. 1, 8, 12 and others, when press-down force is applied to the first actuator 24 by an automatic machine or by a hand finger, the first actuator 24 is moved downwardly while causing the guide pins 28 to move from the outer ends toward the inner ends of the guide holes 27 respectively. In connection with this movement, the pressing levers 3A to 3D are caused to be turned downwardly. When, for example, the lower surface of the electric part body 2 is brought into abutment with the upper surface of the socket body 2, or when the guide pins 28 are brought into abutment with the inner ends of the guide holes 27 respectively, the first actuator 24 is prevented from being moved downwardly and the pressing levers 3A to 3D are prevented from being turned downwardly.

At this position, the engagement with the lock members 7A to 7D is achieved. As a consequence, the pressing down condition of the electric part body 2 made by the latches 6A to 6D and the above contacting condition are maintained. Of course, it may be designed such that after the pressing levers 3A to 3D are slightly turned downwardly from the engaging position with the lock members 7A to 7D, the pressing levers 3A to 3D are restored by the springs to achieve the engagement with the lock members.

As described above, by means of the connection between the pressing levers 3A to 3D and the first actuator 24 through the loosely supporting points, the moving amount is limited and the uppermost position of the first actuator 24 is normally held in a constant position so as to be ready for the next pushing down operation.

As previously described, the pressing levers 3A and 3B are arranged such that their pivotal points and free ends are opposite to each other, and the free ends of the pressing levers 3A and 3B are connected to the first actuator 24 through the loosely supporting points. The arrangement being such that when the pressing lever 3A is turned clockwise upwardly, the other pressing lever 3B is turned counterclockwise upwardly. As a consequence, when the guide pins 28 are brought into abutment with the outer ends of the guide holes 27, the pressing levers 3A and 3B and the first actuator 24 are prevented from further movement, thereby enabling to positively establish the uppermost positions.

Furthermore, the second actuator 25 is resiliently held by a coil spring 29 interposed between the socket body 4 and the second actuator 25. As a result, upwardly directing force is applied to the second actuator 25. The upward and downward movement is guided by slide fitting a guide element 31 extending downwardly from a frame element 30 of the second actuator 25 into a guide groove 32 formed in a side surface of the socket body 4. By slide fitting a guide pin 33 projecting from an inner surface of the guide element 31 into a guide groove 34 formed in an inner surface of the guide groove 32, the second actuator 25 is allowed to be moved upwardly and downwardly within a range of the guide groove 34.

As described above, when the first actuator 24 is pressed down from the uppermost position as shown in Figs. 1, 7 and others, the pressing levers 3A to 3D are simultaneously turned downwardly in connection with this motion, and press the latches 6A to 6D respectively to cause the latches to engage with the edge portions of the electric part body 2 so that the electric part body 2 is pressed downwardly. As a consequence, the terminals arranged on the lower surface of the electric part body 2 are brought into contact with the corresponding contacts 9 under pressure. The pressing levers 3A to 3D are brought into engagement with the lock members 7A to 7D in the vicinity of the lowermost position, thereby maintaining the pressure contacting condition.

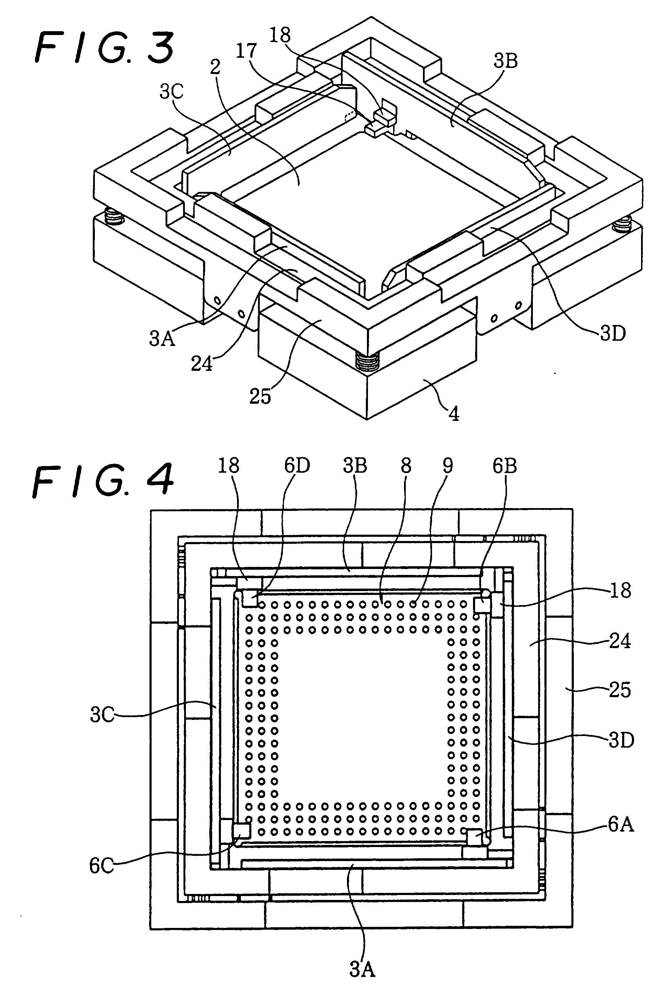

Next, as shown in Figs. 3, 8, 12 and others, in the condition where the pressing levers 3A and 3D are locked (contacting condition maintaining state), when the second actuator 25 is moved downwardly against the spring 29, the frame elements 30, as shown in Figs. 9, 13 and others, displace the hook portions 20 of the lock members 7A to 7D outwardly. As a results, the engagement between each hook portion 20 and each retaining claw element 22 is removed, and the pressing levers 3A to 3D are turned upwardly by resilient force of the spring 13, and at the same time the first actuator 24 is moved upwardly.

When the press-down force of the second actuator 25 is removed, this actuator is moved upwardly against the force of the spring 29, and standbys for the next press-down operation as shown-in Figs. 1, 7 and others. In that condition, the electric part is removed from the socket body.

As means for unlocking the lock members 7A to 7D at the time the second actuator 25 is pressed downwardly, for example, a pressure bearing element 34 of a cantilever construction projects backwardly of the hook portion 20, and a slant surface 35 corresponding to the pressure bearing element 34 is formed on a lower surface of the frame element 30 of the second actuator 25, such that when the second actuator 25 is pressed down, the slant surface 35 presses an upwardly directing projection 37 on a distal end of the pressure bearing element 34 outwardly to raise the hook portion 20 upwardly so as to displace the same outwardly against the resiliency of the raised portion 21, thereby removing the engaging condition with the pressing levers 3A to 3D.

As described in the foregoing, the pressing down of the electric part and its removal can be performed sequentially by means of operation of the first and second actuators 24 and 25.

The present invention is not limited to the above embodiments, and many modifications can be made without departing from the spirit and scope of the present invention. For example, instead of using the first and second actuators, a press-down operation portion may be provided to each pressing lever in order to directly press down the electric part.

## Claims

1. A contact condition maintaining device for use in an electric part socket including a socket (4) having a plurality of contacts (9), an electric part (1) having a plurality of terminals being placed on said socket, said terminals being brought into contact with said contacts respectively when a press-down force is applied to a body of said electric part, the contacting condition maintaining device comprising, as means for pressing down said electric part body, pressing levers (3A, 3B) provided to each of at least two opposite sides of said electric part (1) and turnable upwardly and downwardly along said opposite sides, and latches (6A, 6B) corresponding to said pressing levers and each engageable with an edge portion of said electric part when said pressing levers are turned downwardly, so as to press down said electric part body, characterized in the there are provided lock members (7A, 7B) corresponding to said pressing levers and adapted to prohibit said pressing levers from being turned upwardly when said pressing levers are turned downwardly, so as to maintain a pressing down condition of said electric part body by said latches, and in that one of said levers (3A) is pivotally supported at a basal end thereof on one end side of said electrical part (1), and the other lever (3B) is pivotally supported at the basal end thereof on the other end side of said electrical part (1), free ends of said levers extending in opposite directions with respect to each other from pivotal points thereof and being engageable with said lock members (7A, 7B), each latch (6A, 6B) being engagable with said electric part (1) at a location displaced from the extending direction of the respective pressing lever (3A, 3B), said locations being at diagonally opposite corners of the electric part (1).

2. A contact condition maintaining cevice for use in an electric part socket as claimed in Claim 1, further comprising an actuator (24) mounted on an upper part of said socket (1) for movement upwardly and downwardly and adapted to press down said pressing levers (3A, 3B) when said actuator is moved downwardly.

3. A contact condition maintaining device for use in an electric part socket as claimed in Claim 1, further comprising a first actuator (24) mounted on an upper part of said socket (4) for movement upwardly and downwardly and adapted to press down said pressing lever (3A, 3B) when said first actuator is moved downwardly, and a second actuator 25) mounted on an upper part of said socket body for movement upwardly and downwardly and adapted to displace said lock members (7A, 7B) to unlocking positions respectively.

4. A contacting condition maintaining device for use in an electric part socket as claimed in Claim 1, 2 or 3, in which each of said latches is a projection (6A, 6B) formed on each of said pressing levers (3A, 3B).

5. A contacting condition maintaining device for use in an electric part socket as claimed in Claim 1, 2 or 3, in which said latches (6A, 6B) are turnably mounted on said socket body, said latches being turned downwardly when pressed down by said pressing levers (3A, 3B) respectively.

6. A contacting condition maintaining device for use in an electric part socket as claimed in Claim 1, 2 or 3, in which said levers (3A, 3B, 3C, 3D) are provided to four sides of said electric part (1) and pivotable upwardly and downwardly along said four sides, said latches (6A, 6B, 6C, 6D) being turned downwardly when pressed down by said pressing levers respectively.

7. A contacting condition maintaining device for use in an electric part socket as claimed in Claim 2 or 3, in which free ends of said pressing levers (3A, 3B) are connected to said actuators (24,25) through loosely supporting points, respectively.

## Patentansprüche

1. Kontaktzustandhaltevorrichtung zur Verwendung in einer Fassung für ein elektrisches Bauteil, mit einer Fassung (4) mit mehreren Kontakten (9), einem elektrischen Bauteil (1) mit mehreren auf der Fassung plazierten Anschlüssen, wobei die Anschlüsse jeweils mit den Kontakten in Kontakt gebracht werden, wenn auf einen Körper des elektrischen Bauteils eine Niederdrückkraft ausgeübt wird, wobei die Kontaktzustandhaltevorrichtung als Mittel zum Niederdrücken des Körpers des elektrischen Bauteils Preßhebel (3A, 3B), die an jeder von mindestens zwei einander gegenüberliegenden Seiten des elektrischen Bauteils (1) vorgesehen und nach oben und unten entlang den einander gegenüberliegenden Seiten drehbar sind, und den Preßhebeln entsprechende Sperrklinken (6A, 6B), die jeweils mit einem Randteil des elektrischen Bauteils in Eingriff gebracht werden können, wenn die Preßhebel nach unten gedreht werden, um den Körper des elektrischen Bauteils nach unten zu drücken, umfaßt, dadurch gekennzeichnet, daß den Preßhebeln entsprechende Verriegelungsglieder (7A, 7B) vorgesehen sind, die so ausgelegt sind, daß sie verhindern, daß die Preßhebel nach oben gedreht werden, wenn die Preßhebel nach unten gedreht sind, um durch die Sperrklinken einen Niederdrückkzustand des Körpers des elektrischen Bauteils aufrechtzuerhalten, und daß einer der Hebel (3A) an einem Grundende davon an einer Endseite des elektrischen Bauteils (1) schwenkbar gestützt ist und der andere Hebel (3B) an dem Grundende davon an der anderen Endseite des elektrischen Bauteils (1) schwenkbar gestützt ist, wobei sich freie Enden der Hebel bezüglich einander von Drehpunkten davon in entgegengesetzten Richtungen erstrecken und mit den Verriegelungsgliedern (7A, 7B) in Eingriff gebracht werden können, wobei jede Sperrklinke (6A, 6B) an einer Stelle mit dem elektrischen Teil (1) in Eingriff gebracht werden kann, die von der Erstreckungsrichtung des jeweiligen Preßhebels (3A, 3B) versetzt ist, wobei die Stellen an diagonal gegenüberliegenden Ecken des elektrischen Bauteils (1) liegen.

2. Kontaktzustandhaltevorrichtung zur Verwendung in einer Fassung für ein elektrisches Bauteil nach Anspruch 1, weiterhin umfassend ein an ein oberes Teil der Fassung (1) angebrachtes Betätigungsglied (24) zur Bewegung nach oben und unten, das so ausgelegt ist, daß es die Preßhebel (3A, 3B) nach unten drückt, wenn das Betätigungsglied nach unten bewegt wird.

3. Kontaktzustandhaltevorrichtung zur Verwendung in einer Fassung für ein elektrisches Bauteil nach Anspruch 1, weiterhin umfassend ein an ein oberes Teil der Fassung (4) angebrachtes ersten Betätigungsglied (24) zur Bewegung nach oben und unten, das so ausgelegt ist, daß es die Preßhebel (3A, 3B) nach unten drückt, wenn das erste Betätigungsglied nach unten bewegt wird, und ein zweites an ein oberes Teil des Fassungskörpers angebrachtes zweites Betätigungsglied (25) zur Bewegung nach oben und unten, das so ausgelegt ist, daß es die Verriegelungsglieder (7A, 7B) jeweils in Entriegelungsstellungen verschiebt.

4. Kontaktzustandhaltevorrichtung zur Verwendung in einer Fassung für ein elektrisches Bauteil nach Anspruch 1, 2 oder 3, bei der es sich bei jeder der Sperrklinken um einen an jedem der Preßhebel (3A, 3B) angeformten Vorsprung (6A, 6B) handelt.

5. Kontaktzustandhaltevorrichtung zur Verwendung in einer Fassung für ein elektrisches Bauteil nach Anspruch 1, 2 oder 3, bei der die Sperrklinken (6A, 6B) drehbar an dem Fassungskörper angebracht sind, wobei die Sperrklinken nach unten gedreht werden, wenn sie jeweils von den Preßhebeln (3A, 3B) nach unten gedrückt werden.

6. Kontaktzustandhaltevorrichtung zur Verwendung in einer Fassung für ein elektrisches Bauteil nach Anspruch 1, 2 oder 3, bei der die Hebel (3A, 3B, 3C, 3D) an vier Seiten des elektrischen Teils (1) vorgesehen sind und entlang den vier Seiten nach oben und unten geschwenkt werden können, wobei die Sperrklinken (6A, 6B, 6C, 6D) nach unten gedreht werden, wenn sie jeweils von den Preßhebeln nach unten gedrückt werden.

7. Kontaktzustandhaltevorrichtung zur Verwendung in einer Fassung für ein elektrisches Bauteil nach Anspruch 2 oder 3, bei der freie Enden der Preßhebel (3A, 3B) über lose stützende Punkte jeweils mit den Betätigungsgliedern (24, 25) verbunden sind.

## Revendications

1. Dispositif de maintien de l'état de contact pour l'utilisation dans une prise femelle d'une pièce électrique, comportant une prise femelle (4) ayant une pluralité de contacts (9), une pièce électrique (1) ayant une pluralité de bornes placées sur ladite prise femelle, lesdites bornes étant mises en contact avec lesdits contacts respectivement lorsqu'une force de pression vers le bas est appliquée à un corps de ladite pièce électrique, le dispositif de maintien de l'état de contact comprenant, comme moyen pour presser ledit corps de pièce électrique vers le bas, des leviers presseurs (3A, 3B) prévus sur chacun d'au moins deux côtés opposés de ladite pièce électrique (1) et pouvant être tournés vers le haut et vers le bas le long desdits côtés opposés, et des loquets (6A, 6B) correspondant auxdits leviers presseurs et pouvant être engagés chacun avec une portion de bord de ladite pièce électrique lorsque lesdits leviers presseurs sont tournés vers le bas, de manière à presser ledit corps de pièce électrique vers le bas, caractérisé en ce qu'il est prévu des organes de verrouillage (7A, 7B) correspondant auxdits leviers presseurs et adaptés pour empêcher lesdits leviers presseurs d'être tournés vers le haut lorsque lesdits leviers presseurs sont tournés vers le bas, de manière à maintenir un état pressé vers le bas dudit corps de pièce électrique par lesdits loquets, et en ce qu'un desdits leviers (3A) est supporté à pivotement à son extrémité basale sur un côté d'extrémité de ladite pièce électrique (1), et l'autre levier (3B) est supporté à pivotement à son extrémité basale sur l'autre côté d'extrémité de ladite pièce électrique (1), les extrémités libres desdits leviers s'étendant dans des directions opposées l'une par rapport à l'autre depuis des points de pivot de ces leviers, et pouvant être engagées avec lesdits organes de verrouillage (7A, 7B), chaque loquet (6A, 6B) pouvant être engagé avec ladite pièce électrique (1) en un emplacement déplacé par rapport à la direction dans laquelle s'étend le levier presseur respectif (3A, 3B), lesdits emplacements étant à des coins diagonalement opposés de la pièce électrique (1).

2. Dispositif de maintien de l'état de contact pour l'utilisation dans une prise femelle d'une pièce électrique selon la revendication 1, comprenant en outre un actionneur (24) monté sur une partie supérieure de ladite prise femelle (4) pour se déplacer vers le haut et vers le bas et adapté à presser lesdits leviers presseurs (3A, 3B) vers le bas lorsque ledit actionneur est déplacé vers le bas.

3. Dispositif de maintien de l'état de contact pour l'utilisation dans une prise femelle d'une pièce électrique selon la revendication 1, comprenant en outre un premier actionneur (24) monté sur une partie supérieure de ladite prise femelle (4) pour se déplacer vers le haut et vers le bas et adapté à presser ledit levier presseur (3A, 3B) vers le bas lorsque ledit premier actionneur est déplacé vers le bas, et un second actionneur (25) monté sur une partie supérieure dudit corps de la prise femelle pour se déplacer vers le haut et vers le bas et adapté à déplacer lesdits organes de verrouillage (7A, 7B) dans des positions respectives de déverrouillage.

4. Dispositif de maintien de l'état de contact pour l'utilisation dans une prise femelle d'une pièce électrique selon la revendication 1, 2 ou 3, dans lequel chacun desdits loquets est une projection (6A, 6B) formée sur chacun desdits leviers presseurs (3A, 3B).

5. Dispositif de maintien de l'état de contact pour l'utilisation dans une prise femelle d'une pièce électrique selon la revendication 1, 2 ou 3, dans lequel lesdits loquets (6A, 6B) sont montés de manière à pouvoir tourner sur ledit corps de prise femelle, lesdits loquets étant tournés vers le bas lorsqu'ils sont pressés vers le bas par lesdits leviers presseurs (3A, 3B) respectivement.

6. Dispositif de maintien de l'état de contact pour l'utilisation dans une prise femelle d'une pièce électrique selon la revendication 1, 2 ou 3, dans lequel lesdits leviers (3A, 3B, 3C, 3D) sont prévus aux quatre côtés de ladite pièce électrique (1) et peuvent pivoter vers le haut et vers le bas le long desdits quatre côtés, lesdits loquets (6A, 6B, 6C, 6D) étant tournés vers le bas lorsqu'ils sont pressés vers le bas par lesdits leviers presseurs respectivement.

7. Dispositif de maintien de l'état de contact pour l'utilisation dans une prise femelle d'une pièce électrique selon la revendication 2 ou 3, dans lequel les extrémités libres desdits leviers presseurs (3A, 3B) sont connectées auxdits actionneurs (24, 25) par des points de support lâches respectifs.
